(19) Europäisches Patentamt
European Patent Office
Office européen des brevets

(11) **EP 4 048 025 B1**

(12) **EUROPEAN PATENT SPECIFICATION**

(45) Date of publication and mention
of the grant of the patent:
**01.04.2026 Bulletin 2026/14**

(21) Application number: **22157197.9**

(22) Date of filing: **17.02.2022**

(51) International Patent Classification (IPC):
*H05B 6/06* *(2006.01)*

(52) Cooperative Patent Classification (CPC):
**H05B 6/062**

(54) **INDUCTION HEATING APPARATUS AND METHOD FOR CONTROLLING INDUCTION HEATING APPARATUS**

INDUKTIONSHEIZVORRICHTUNG UND VERFAHREN ZUR STEUERUNG EINER INDUKTIONSHEIZVORRICHTUNG

DISPOSITIF DE CHAUFFAGE PAR INDUCTION ET PROCÉDÉ DE COMMANDE DE DISPOSITIF DE CHAUFFAGE PAR INDUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.02.2021 KR 20210021180**

(43) Date of publication of application:
**24.08.2022 Bulletin 2022/34**

(73) Proprietor: **LG Electronics Inc.**
**SEOUL 07336 (KR)**

(72) Inventors:
• **JUNG, Seok Jin**
**08592 Seoul (KR)**
• **KIM, Tae Sung**
**08592 Seoul (KR)**

(74) Representative: **Ter Meer Steinmeister & Partner Patentanwälte mbB**
**Nymphenburger Straße 4**
**80335 München (DE)**

(56) References cited:
**EP-A1- 2 642 820      EP-A1- 3 481 147**
**EP-A1- 3 764 740      JP-A- 2009 295 330**

**Description**

**TECHNICAL FIELD**

The present disclosure relates to an induction heating apparatus and a method for controlling the induction heating apparatus.

**BACKGROUND**

EP 3481147 A1 describes an induction heating device that includes a working coil, an inverter, an inverter driving unit configured to apply a switching signal to the inverter to enable the inverter to perform a switching operation, a control unit configured to generate and apply a control signal to the inverter driving unit to cause the inverter driving unit to generate the switching signal based on the control signal, and a determination unit configured to determine a type of an object disposed on the induction heating device based on (i) a first resonant current value measured from the working coil in response to operation of the inverter by the switching signal having a first operation frequency and (ii) a second resonant current value measured from the working coil in response to operation of the inverter by the switching signal having a second operation frequency.

JP 2009 295330 A describes an induction heating cooker. A heating efficiency is calculated based on a ratio between an input current and an output current to and from an inverter circuit, supplying high-frequency current to a heating coil. The heating efficiency calculated is displayed on an efficiency display part provided at a top plate.

EP 3764740 A1 describes a method for controlling an induction cooking hob, the method including an operation mode for estimating the energy efficiency.

EP 2642820 A1 describes an induction-heating cooking system.

An induction heating apparatus is a mechanism that heats a container by generating an eddy current in a metal container, using a magnetic field generated around a working coil.

To cook food using the induction heating apparatus, a user puts food in a container and sets a target output power value corresponding to a desired thermal power supplied to the container. Hence, the induction heating apparatus may drive a working coil based on the target output power value set by the user. The user may heat the food using the induction heating apparatus for a time required until the food is sufficiently cooked.

If the user cooks commercially available products using the induction heating device, the user has to check the cooking method of the product one by one, set the target output power value for each product, and drive the induction heating apparatus during the operation time.

To make this process more convenient, KR 10-2012-0117463 discloses a technology for recommending a cooking method (i.e., a target output power value and an operation time) based on recognized data after the user recognizes a product to be cooked through a recognition device.

However, such a technology recommends the same target output power value and the same operation time, if the products to be cooked are the same. In other words, regardless of the type of container containing the product to be cooked, the same target output power value and the same operation time are recommended. Accordingly, if the energy generated by the working coil is not completely transmitted due to properties such as the size and material of the container, there could be a problem in that the food fails to be cooked completely.

Therefore, there are needs for developing an induction heating device that is capable of improving such a disadvantage.

**SUMMARY**

An object of the present disclosure is to provide an induction heating apparatus that may cook food even with different container properties, and a method for controlling the induction heating apparatus.

Objects according to the present disclosure are not limited to the above ones, and other aspects and advantages that are not mentioned above can be clearly understood from the following description and can be more clearly understood from the embodiments set forth herein. One or more of these objects are solved by the features of the independent claims.

According to the present disclosure, a controller provided in an induction heating apparatus may be configured to adjust at least one of an operation time and a target output power value based on a container (or vessel) efficiency index.

Due to such a configuration of the induction heating apparatus, food may be completely cooked even with different container properties.

According to one aspect, a method for controlling an induction heating apparatus, in particular an induction heating apparatus according to any one of the herein described embodiments, includes steps of: receiving an operation time and a target output power value corresponding to product information; driving a working coil based on the operation time and the target output power value; measuring a resonance current value of the working coil; comparing the resonance current value with a preset reference current value; calculating a container efficiency index of a container provided on the working coil based on an actual output power value of the working coil and the target output power value, when or if the resonance current value exceeds the reference current value; and adjusting at least one of the operation time and the target output power value based on the container efficiency index.

The method for controlling an induction heating apparatus may include one or more of the following features:

The target output power value and/or the operation time may be determined based on a preset maximum output power value. That is, the target output power value may be equal to or smaller than the maximum output power value.

The actual output power value may be determined based on an input current value sensed by an input current sensor and/or based on an input voltage value sensed by an input voltage sensor.

The product information may relate to a product to be prepared or cooked or heated. The product information may be input by a user into the induction heating apparatus, or may be provided by a user terminal and/or a server. The determination of the operation time and the target output power value based on product information may be performed by the controller of the induction heating apparatus and/or by the user terminal and/or by the server. The user terminal 200 may be a mobile terminal, e.g., a mobile phone or a PDA.

The container may be placed on a heating region corresponding to the working coil and/or contain the product to be heated.

The step of receiving the operation time and the target output power value corresponding to the product information may include steps of inputting the product information to a user terminal; transmitting the product information to the managing server from the user terminal; and transmitting the operation time and the target output power value that correspond to the product information from the managing server, e.g., to the user terminal. Alternatively or additionally, the step of receiving the operation time and the target output power value corresponding to the product information may include steps of inputting the product information to the induction heating apparatus; transmitting the product information to a managing server; and receiving the operation time and the target output power value that correspond to the product information from the managing server.

The step of calculating the container efficiency index may include a step of dividing the actual output power value by the target output power value to calculate the container efficiency index.

The step of adjusting at least one of the operation time and/or the target output power value based on the container efficiency index may include steps of: determining whether the target output power value is equal to the maximum output power value; and adjusting at least one of the operation time and/or the target output power value based on the result of the determination.

The step of adjusting at least one of the operation time and/or the target output power value based on the container efficiency index may include steps of: adjusting the operation time based on the container efficiency index when the target output power value is equal to the maximum output power value; and adjusting the target output power value based on the container efficiency index unless the target output power value is equal to the maximum output power value.

The step of adjusting the target output power value based on the container efficiency index unless the target output power value is equal to the maximum output power value may include steps of: re-adjusting the maximum output power value to be the target output power value when the adjusted target output power value exceeds the maximum output power value; and adjusting the operation time based on the initial, i.e., the received, target output power value, the maximum output power value and the container efficiency index.

According to a further aspect, an induction heating apparatus includes a working coil disposed in a position corresponding to a heating region; an inverter circuit comprising a plurality of switching elements and configured to supply a current to the working coil; a drive circuit configured to supply a switching signal to each of the switching elements provided in the inverter circuit; a controller configured to drive the working coil by supplying a control signal for adjusting the switching signal to the drive circuit; a communication unit configured to receive an operation time and a target output power value corresponding to product information; and a resonance current sensor configured to measure a resonance current value of the working coil. The controller may be configured to perform a method of controlling the induction heating apparatus according to any one of the herein described embodiments. The controller may be configured to drive the working coil based on the operation time and the target output power value, to measure a resonance current value of the working coil through the resonance current sensor, to compare the resonance current value with a preset reference current value, to calculate a container efficiency index of the container provided on the working coil based on an actual output power value of the working coil and the target output power value, and to adjust at least one of the operation time or the target output power value based on the container efficiency index.

The method may further comprise: driving the working coil based on the adjusted target output power value and/or the adjusted operation time. That is, the working coil may be driven based on the at least one adjusted parameter, the parameter including the target output power value and the operation time. Also, if one of the target output power value and the operation time is not adjusted, the working coil may be driven correspondingly based on the received target output power value or operation time.

According to a further aspect, an induction heating apparatus includes a working coil disposed in a position corresponding to a heating region; an inverter circuit comprising a plurality of switching elements and configured to supply a current to the working coil; a drive circuit configured to supply a switching signal to each of the switching elements provided in the inverter circuit; a resonance current sensor configured to measure or sense a resonance current value of the working coil and a controller configured to drive the working coil by supplying a control signal for adjusting the switching signal to the drive circuit. The controller may be configured to perform a method of controlling the induction heating apparatus according to any one of the herein described embodiments. The controller may be configured to drive the working coil based on an operation time and a target output power value determined based on product information, to measure a resonance current value of the working coil through the resonance current sensor, to compare the resonance current value with a preset reference current value, to calculate a container efficiency index of the container provided on the working coil based on an actual output power value of the working coil and the target output power value, and to adjust at least one of the operation time or the target output power value based on the container efficiency index. The induction heating apparatus may further include a communication unit configured to receive information from a user terminal and/or a server, e.g., an operation time and a target output power value corresponding to product information. The user terminal 200 may be a mobile terminal, e.g., a mobile phone or a PDA.

The induction heating apparatus according to any one of these aspects may include one or more of the following features:

The product information may relate to a product to be prepared or cooked or heated. The product information may be input by a user into the induction heating apparatus, or may be provided by a user terminal and/or a server. The determination of the operation time and the target output power value based on product information may be performed by the controller of the induction heating apparatus and/or by the user terminal and/or by the server.

The target output power value and/or the operation time may be determined based on a preset maximum output power value. That is, the target output power value may be equal to or smaller than the maximum output power value.

The induction heating apparatus may further include an input current sensor configured to measure or sense an input current value, e.g., a (actual) current value input from an external power source and/or supplied into the inverter circuit and/or supplied into the induction heating apparatus, and/or an input voltage sensor configured to measure an input voltage value, e.g., a (actual) voltage value input from an external power source and/or supplied into the inverter circuit and/or supplied into the induction heating apparatus.

The communication unit may be configured to receive the operation time and/or the target output power value that correspond to the product information (e.g., input to a user terminal) from a managing server. Also, the communication unit may be configured to transmit product information, e.g., input by a user to the induction heating apparatus, to a managing server and to receive the operation time and/or the target output power value that correspond to the product information from the managing server.

The controller may be configured to divide the actual output power value by the target output power value to calculate the container efficiency index. The controller may be configured to determine the actual output power value based on an input current value sensed by the input current sensor and/or based on an input voltage value sensed by the input voltage sensor.

The controller may be configured to determine whether the target output power value is equal to a (preset) maximum output power value, and to adjust at least one of the operation time and the target output power value based on the result of the determination.

The controller may be configured to adjust the operation time based on the container efficiency index, when the target output power value is equal to the maximum output power value. The controller may be configured to adjust the target output power value based on the container efficiency index, unless the target output power value is equal to the maximum output power value.

The controller may be configured to re-adjust the maximum output power value to be the target output power value, when the adjusted target output power value exceeds the maximum output power value. The controller may be configured to adjust the operation time based on the initial, i.e., received, target output power value, the maximum output power value and the container efficiency index.

The induction heating apparatus may further include a manipulation unit for receiving a user input, e.g., corresponding to or including the product information.

According to another aspect, a system for controlling an induction heating apparatus is provided including an induction heating apparatus, e.g., according to any one of the herein described embodiments, and at least one of a managing server and a user terminal. The server and/or the user terminal may be configured for determining at least one of an operation time and a target output power value based on product information of a product to be cooked/prepared, and for transmitting the operation time and the target output power value to the induction heating apparatus. The product information may relate to a product to be prepared or cooked or heated. The product information may be input by a user into the induction heating apparatus, the user terminal and/or the managing server.

According to the embodiments, at least one of the operation time or the target output power value can be adjusted based on the container (or vessel) efficiency index. Accordingly, the induction heating apparatus according to the embodiments may cook food even with different container properties. Food may be completely cooked even with different container properties using the induction heating apparatus according to the embodiments, thereby user satisfaction is increased.

Specific effects are described along with the

## BRIEF DESCRIPTION OF DRAWINGS

FIG. 1 is an exploded perspective view of an induction heating apparatus according to one embodiment of the present disclosure;

FIG. 2 is a circuit view of an induction heating apparatus according to an embodiment of the present disclosure;

FIG. 3 is a flow chart showing a method for controlling the induction heating apparatus according to one embodiment;

FIG. 4 is a flow chart specifically showing a method for adjusting at least one of an operation time and a target output power value based on a container efficiency index in the method for controlling the induction heating apparatus according to the embodiment;

FIG. 5 shows an upper plate of the induction heating apparatus according to one embodiment; and

FIG. 6 shows a display provided in an induction heating apparatus according to another embodiment.

## DETAILED DESCRIPTION

The above-described aspects, features and advantages are specifically described hereunder with reference to the accompanying drawings such that one having ordinary skill in the art to which the present disclosure pertains can easily implement the technical idea of the disclosure. In the disclosure, detailed descriptions of known technologies in relation to the disclosure are omitted if they are deemed to make the gist of the disclosure unnecessarily vague. Below, preferred embodiments according to the disclosure are specifically described with reference to the accompanying drawings. In the drawings, identical reference numerals can denote identical or similar components.

It will be understood that although the terms first, second, etc. may be used herein to describe various elements, these elements should not be limited by these terms. These terms are generally only used to distinguish one element from another. Unless otherwise stated, it goes without saying that the first component may be the second component.

Hereinafter, expressions of 'a component is provided or disposed in an upper or lower portion' may mean that the component is provided or disposed in contact with an upper surface or a lower surface. The present disclosure is not intended to limit that other elements are provided between the components and on the component or beneath the component.

It will be understood that when an element is referred to as being "connected with" another element, the element can be directly connected with the other element or intervening elements may also be present. In contrast, when an element is referred to as being "directly connected with" another element, there are no intervening elements present.

Unless otherwise stated, it goes without saying that each element may be singular or plural.

A singular representation may include a plural representation unless it represents a definitely different meaning from the context. Terms such as "include" or "has" are used herein and should be understood that they are intended to indicate an existence of several components, functions or steps, disclosed in the specification, and it is also understood that greater or fewer components, functions, or steps may likewise be utilized.

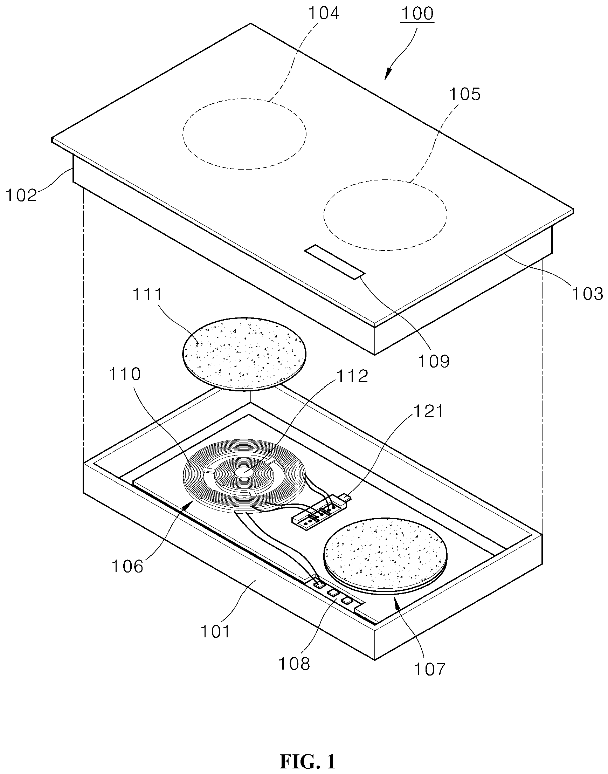

FIG. 1 is an exploded perspective view of the induction heating apparatus according to one embodiment of the present disclosure.

Referring to FIG. 1, the induction heating apparatus 100 according to the embodiment may include a case 101 defining a main body, and a cover plate 102 coupled to the case 101 and sealing the case 101.

The cover plate 101 may be coupled to an upper surface of the case to close the space formed in the case 101 from the outside. The cover plate 102 may include a top plate 103 on which an object to be heated (i.e., a container for cooking food) is provided. The top plate 103 may be made of a tempered glass material such as ceramic glass, but is not limited thereto. The material of the top plate 103 may vary according to embodiments.

Heating regions (or heating areas) 104 and 105 corresponding to working coil assemblies 106 and 107, respectively, may be formed in the top plate 106. Lines or figures corresponding to the heating regions 104 and 105 may be printed or displayed on the top plate 103 in order for a user to clearly recognize the positions of the heating regions 104 and 105.

The case 101 may have a hexahedral shape with an open top. The working coil assembly 106 and 107 for heating a container or vessel may be disposed in the space formed inside the case 101. In addition, an interface unit (or interface) 108 may be provided inside the case 101 and have functions to adjust a power level of each heating region 104 and 105 and display related information to the induction heating apparatus 100. The interface unit 108 may be a touch panel that is capable of both inputting information and displaying information by touch, but the interface unit 108 having a different structure may be provided according to embodiments.

A manipulation region 109 may be disposed at a position corresponding to the interface unit 108 in the top plate 103. For user manipulation, characters or images may be printed on the manipulation region 109. The user may perform a desired operation by touching a specific point of the manipulation region 108 with reference to the characters or images pre-printed on the manipulation region 109.

The user may set the power level of each heating region 104 and 105 through the interface unit 108. The power level may be indicated by a number (e.g., 1 to 9) on the manipulation region 109. When the power level for each heating region 104 and 105 is set, the required power value and the heating frequency of the working coil assemblies responding to the respective heating regions 104 and 105 may be determined. A controller may drive each working coil so that the actual output power value can correspond the required power value set by the user based on the determined heating frequency.

A power source part 121 (or power supply) may be provided in the space formed inside the case 101 for supplying power to the working coil assemblies 106 and 107 or the interface unit 108.

In the embodiment of FIG. 1, two working coil assemblies (i.e., a first working coil assembly 106 and a second working coil assembly 107) are disposed inside the case 101. However, three or more working coil assemblies may be provided in the case 101 according to embodiments.

Each working coil assembly 106 and 107 may include a working coil configured to an induced magnetic field using a high frequency alternating current supplied by the power source part 121, and an insulating sheet configured to protect the coil from heat generated by the container. For example, the first working assembly 106 shown in FIG. 1 may include a first working coil 110 for heating the container put in (or provided on) the first heating region 104 and, optionally, a first insulating sheet 111. Although not shown in the drawings, the second working assembly 107 may include a second working coil and, optionally, a second insulating sheet. The insulating sheet may not be provided according to embodiments.

In addition, a temperature sensor may be provided at the center of each working coil. For example, the temperature sensor 112 may be provided in the center of the first working coil 110 as shown in FIG. 1. The temperature sensor may measure the temperature of the container put in (or provided on) each heating region. In one embodiment of the present disclosure, the temperature sensor may be a thermistor temperature sensor having a variable resistance of which a resistance value changes according to the temperature of the container, but is not limited thereto.

In the embodiment, the temperature sensor may output a sensing voltage corresponding to the temperature of the container and the sensing voltage output from the temperature sensor may be transmitted to the controller. The controller may check the temperature of the container based on the magnitude of the sensing voltage output from the temperature sensor. When the temperature of the container is a preset reference value or more, the controller may perform an overheat protection operation of lowering the actual power value of the working coil or stopping the driving of the working coil.

Although not shown in FIG. 1, a circuit board on which a plurality of circuits or elements including the controller may be disposed in the space formed inside the case 101. The controller may perform a heating operation by driving each working coil based on the user's heating start command input through the interface unit 114. When the user inputs a heating terminating command through the interface unit 108, the controller may stop the driving of the working coil to terminate the heating operation.

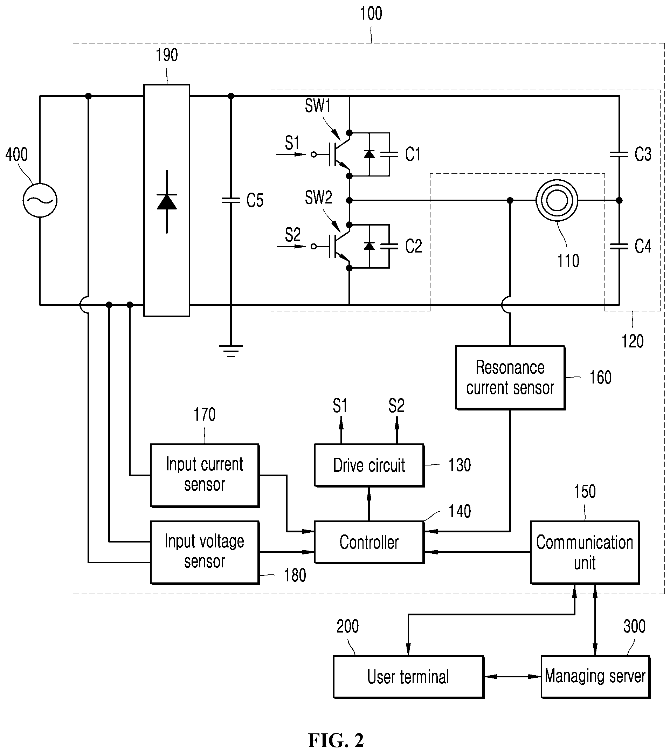

FIG. 2 is a circuit view of an induction heating apparatus according to an embodiment of the present invention.

Referring to FIG. 2, the induction heating apparatus 100 may include a working coil 110, an inverter circuit (or inverter) 120, a drive circuit 130, a controller 140, a communication unit (or a communication device) 150 and a resonance current sensor 160. In addition, the induction heating apparatus 100 according to this embodiment may further include an input current sensor 170, an input voltage sensor 180, a rectifier circuit 190 and a smoothing capacitor C5.

The working coil 110 may be provided in a position corresponding to the heating region 104. As currents flow, the working coil 110 may heat an object to be heated through the resonance current generated between the working coil 110 and the object. The working coil 110 may be supplied current from the inverter circuit 120.

The inverter circuit 120 may include a plurality of switching elements and supply current to the working coil 110.

The inverter circuit 120 may include a first switching element SW1 and a second switching element SW2. The inverter circuit 120 of the induction heating apparatus 100 according to the embodiment shown in FIG. 2 may be configured to be a half-bridge circuit including two switching elements SW1 and SW2. However, the inverter circuit 120 may be configured to be a full-bridge circuit including four switching elements according to another embodiment. Hereinafter, an embodiment in which the inverter circuit 120 is configured as the half-bridge circuit as shown in FIG. 2 will be mainly described.

The inverter circuit 120 may convert the current supplied from an external power source (or power supply) 400 and supply the converted current to the working coil 110. At this time, the current supplied from the external power source 400 may be smoothed through the rectifier circuit 190 and the smooth capacitor C5 to be supplied to the inverter circuit 120.

The rectifier circuit (or rectifier) 190 may include a plurality of diode elements. In one embodiment of the present disclosure, the rectifier circuit 190 may be a bridge diode. The rectifier 190 may rectify the AC input voltage supplied from the external power source 400 to output a voltage having a pulsating waveform.

The smoothing capacitor C5 may smooth the voltage rectified by the rectifier circuit 190 to output a DC link voltage.

The DC link voltage input to the inverter circuit 120 may be converted into an AC current by the turn-on and turn-off (i.e., the switching operation) of the switching elements SW1 and SW2 provided in the inverter circuit 120. The AC current converted by the inverter circuit 120 may be supplied to the working coil 110. Accordingly, as a resonance phenomenon occurs in the working coil 110, an eddy current may flow through the container to heat the container.

The drive circuit 130 (or driver) may supply a switching signal to each of the switching elements SW1 and SW2 provided in the inverter circuit 120. The switching signal may be a pulse width modulation (PWM) signal having a preset duty ratio and frequency.

As the drive circuit 130 supplies the switching signal, each of the switching elements SW1 and SW2 provided in the inverter circuit 120 may be turned on or off. At this time, the first switching element SW1 and the second switching element SW2 may be turned on or off by the first witching signal S1 and the second switching signal S2, respectively. When each of the switching signals S1 and S2 is a high value, each of the switching elements SW1 and SW2 may be turned on. When each of the switching signals S1 and S2 is a low value, each of the switching elements SW1 and SW2 may be turned off.

The drive circuit 130 may generate the switching signal based on a control signal received from the controller 140 to supply the switching signal to the inverter circuit 120.

The controller 140 may control the overall operation of the induction heating apparatus 100. The controller 140 may be implemented by including a physical element having at least one of ASICs (Application Specific Integrated Circuits), DSPs (Digital Signal Processors), DSPDs (Digital Signal Processing Devices), PLDs (Programmable Logic Devices), FPGAs (Field Programmable Gate Arrays), micro-controllers or microprocessors.

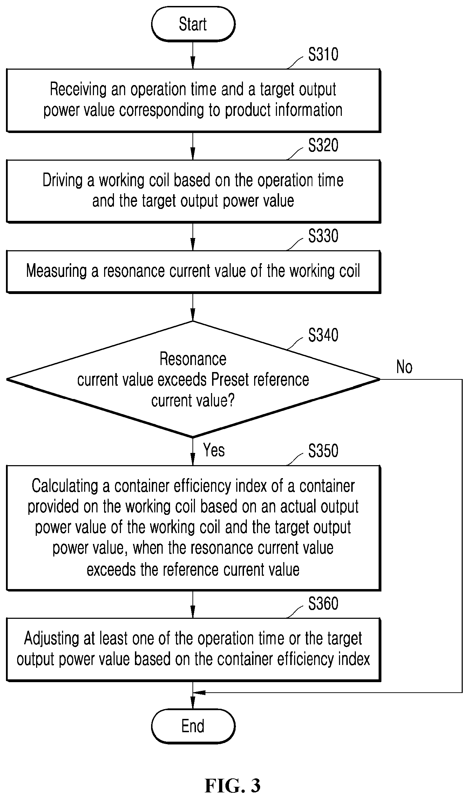

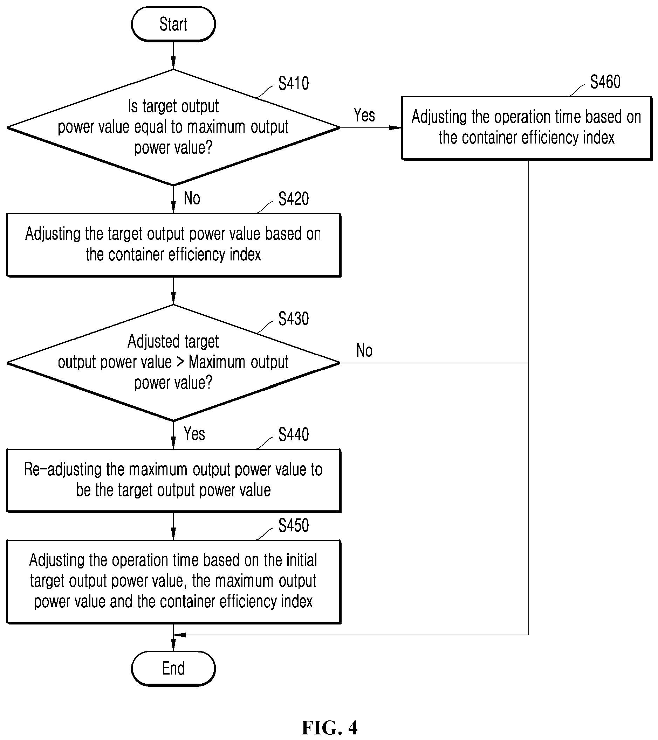

The controller 140 may drive the working coil 110 by supplying the control signal for adjusting the switching signals to the drive circuit 130. In this instance, the controller 140 may drive the working coil 110 based on an operation time and a target output power value. The controller 140 may measure a resonance current value of the working coil 110 by controlling the resonance sensor 160, which will be described later, and compare the resonance current value with a preset reference current value. When the resonance current value is more than the reference current value, the controller 140 may calculate (or determine) a container efficiency index of the container put on the working coil 110 based on an actual output power value and based on a target output power value of the working coil 110, and adjust at least one of the operation time and the target output power value based on the calculated container efficiency index. The specific control operation of the controller 140 will be described later, referring to FIGS. 3 and 4.

The communication unit (or communication device) 150 may receive the operation time and/or the target output power value corresponding to the product information, e.g., from a server and/or a user terminal.

Hereinafter, the product may refer to a target object that the user of the induction heating apparatus 100 purchases at a store such as a mart or a convenience store and intends to cook it using the induction heating apparatus 100. The operation time may mean the time during which the induction heating apparatus 100 is required to operate for complete cooking of the product. The target output power value may mean a value corresponding to the energy output by the induction heating apparatus 100 for complete cooking of the product during the operation time.

The communication unit 150 may receive from a managing server 300 the operation time and/or the target output power value that correspond the product information input to or provided by a user terminal 200. The user terminal 200 may be a mobile terminal, e.g., a mobile phone or a PDA.

More specifically, as the user inputs the product information to the user terminal 200, the induction heating apparatus 100 may recognize which product is finally cooked from the product information. At this time, the user may input the product information by inputting a barcode, QR code and RFID tag of the product, for example. The user terminal 200 may transmit the product information to the managing server 300. Hence, the managing server 300 may search for an operation time and/or a target output power value corresponding the product information received from the user terminal 200, and the managing server may transmit the operation time and/or the target output power value to the communication unit 150 of the induction heating apparatus 100. Through this process, the communication unit 150 may receive the operation time and/or the target output power value corresponding to the product information.

The resonance current sensor 160 may measure a resonance current value, which is the magnitude of the resonance current flowing through the working coil 110. In other words, when the working coil 110 is being driven, the resonance current sensor 160 may measure a resonance current value and transmit the measure value to the controller 140.

The input current sensor 170 may measure an input current value which is a current value supplied to the inverter circuit 120. In other words, the input current sensor 170 may measure a current value supplied from the external power source 400 as the input current value. The input current sensor 170 may measure the current value before being rectified and smoothed by the rectifier circuit 190 and the smoothing capacitor C5. After that, the input current sensor 170 may transmit the measured input current value to the controller 140.

The input voltage sensor 180 may measure an input voltage value which is a voltage value supplied to the inverter circuit 120. In other words, the input voltage sensor 180 may measure the voltage value supplied from the external power source 400 as the input voltage value. Specifically, the input voltage sensor 180 may measure a voltage value before being rectified and smoothed by the rectifier circuit 190 and the smoothing capacitor C5. After that, the input voltage sensor 180 may transmit the measured input voltage value to the controller 140.

FIG. 3 is a flow chart showing a method for controlling the induction heating apparatus according to one embodiment.

Referring to FIG. 3, the induction heating apparatus 100 may receive the operation time and the target output power value corresponding to the product information from the communication unit 150 (S310). The communication unit 150 may receive the operation time and the target output power value, which correspond the product information input to the user terminal 200, from the managing server 300 and/or from the user terminal 200.

Hence, the controller 140 may drive the working coil 110 based on the operation time and the target output power value (S320). At this time, the controller 140 may supply the control signal for generating the switching signal corresponding to the target output power value to the drive circuit 130 during the operation time to drive the working coil 110.

After that or during the driving of the working coil 110 based on the operation time and the target output power value, the controller 140 may measure the resonance current value of the working coil 110 through the resonance current sensor 160 (S330). In other words, the resonance current sensor 160 may measure the resonance current value of the working coil 110 which is the magnitude of the resonance current flowing in the working coil 110, and transmit the result of the measurement to the controller 140.

The controller 140 may compare the resonance current value with a preset reference current value, and determine whether the resonance value exceeds the reference current value (S340). In this instance, the reference current value means a preset current value, e.g., a current value that is a reference for determining whether the driving of the working coil 110 is unstable enough for some of the energy generated by the working coil 110 not to be transmitted to the container but to be circulated inside the induction heating apparatus 100.

The controller 140 may drive the working coil 110 based on the current set operation time and the target output power value, if the resonance current value does not exceed the reference current value, i.e., unless the resonance current value exceeds the reference current value.

Conversely, when the resonance current value exceeds the reference current value, the controller 140 may calculate the container efficiency index based on the actual output power value and the target output power value of the working coil 110 (S350).

The actual output power value may mean an output power value that is actually generated by the currently driving working coil as determined based on the input current value measured by the input current sensor 170 and the input voltage value measured by the input voltage sensor 180. The controller 140 may calculate the actual output power value PR of the working coil 120 from a formula: $PR=V*I*\cos\theta$, with the input current value I, the input voltage value V and a phase difference $\theta$ between the input current value I and the input voltage value V.

The controller 140 may calculate the container efficiency index PEI by dividing the actual output power value PR of the working coil 110 by the target output power value PT. That is, the controller 140 may calculate the container efficiency index PEI based on Equation 1 below:

$$[\text{Equation 1}]$$
$$PEI=PR/PT$$

As one example, when the target output power value PT of the working coil 110 is 1000W and the actual output power value PR of the working coil 110 is 400W, the container efficiency index PEI of the working coil 110 is calculated to be 0.4.

After calculating the container efficiency index, the controller 140 may adjust at least one of the operation time or the target output power value based on the container efficiency index (S360). A specific method for adjusting at least one of the operation time or the target output power value may be described, referring to FIG. 4.

FIG. 4 is a flow chart specifically showing the method for adjusting at least one of the operation time and the target output power value based on the container efficiency index, i.e., in step S360, in the method for controlling the induction heating apparatus according to the embodiment.

Referring to FIG. 4, the controller 140 may determine whether the target output power value is equal to the maximum output power value (S410).

The maximum output power value is a value corresponding to the maximum amount of the energy that the induction heating apparatus 100 is configured to output. Accordingly, the target output power value may be set to have a value greater than the maximum output power value.

Unless the target output power value is equal to the maximum output power value, i.e., if the target output power value is not equal to the maximum output power value, the controller 140 may adjust the target output power value based on the container efficiency index (S420). At this time, the controller 140 may divide the target output power value by the container efficiency index to adjust the target output power value. In other words, the controller 140 may adjust the target output power value based on Equation 2 below:

[Equation 2]

$$PT\_A=PT/PEI$$

Here, PT_A means the adjusted target output power value. As one example, when the container efficiency index PEI is 0.4 and the target output power value PT is 1000W, the adjusted target output power value PT_A may be 2500W.

Hence, the controller 140 may determine whether the adjusted target output power value exceeds the maximum output power value (S430). As one example, when the maximum output power value is 2000W and the adjusted target output power value is 2500W, the controller 140 may determine that the adjusted target value exceeds the maximum output power value.

The target output power value may not be set to have a value greater than the maximum output power value. Accordingly, once determining that the adjusted target output power value exceeds the maximum output power value, the controller 140 may re-adjust the maximum output power value to be the target output power value (S440). As one example, when the maximum output power value is 2000W and the adjusted target output power value is 2500W, the controller 140 may re-adjust the 2000W, which is the maximum output power value, to be the target output power value. That is, the target output power value may be re-adjusted as 2000W.

After re-adjusting the target output power value, the controller 140 may adjust the operation time based on the (initial or received) target output power value, the maximum output power value and the container efficiency index (S450). Specifically, since it cannot completely compensate for insufficient energy transmission caused by the properties of the container by adjusting the target output power value, the controller 140 may additionally or alternatively adjust the operation time.

Here, the (initial or received) target output power value means the target output power value received from the managing server 300, in other words, the target output power value before being adjusted. At this time, to adjust the operation time, the controller 140 may multiply a value obtained by dividing the operation time by the container efficiency index by the ratio of the target output power value to the maximum output power value. The controller 140 may adjust the operation time based on Equation 3 below:

[Equation 3]

$$OT\_A=(OT/PEI)*(PT\_I/PT\_max)$$

OT denotes the operation time, OT_A denotes the adjusted time, PT_I denotes the (initial or received) target output power value, and PT_max denotes the maximum output power value (here equal to the re-adjusted target output power value). As one example, when the operation time OT received through the communication unit 150 is 10 minutes and the initial or received target output power value PT_I is 1000W and the maximum output power value PT_max is 2000W and the container efficiency index PEI is 0.4, the adjusted operation time OT_A may be 12.5 minutes.

If determining that the adjusted target output power value does not exceed the maximum output power value in the step S430, the controller 140 may not adjust the operation time.

If determining that the target output power value is equal to the maximum output power value in the step S410, the controller 140 may adjust the operation time based on the container efficiency index (S460). That is, the controller 140 cannot compensate for insufficient energy transfer due to the properties of the container by using the target output power value, so that the controller 140 may adjust the operation time.

At this time, to adjust the operation time, the controller 140 may adjust the operation time by dividing the operation time by the container efficiency index. The controller 140 may adjust the target output power value based on Equation 4 below:

[Equation 4]

$$OT\_A=OT/PEI$$

As one example, when the container efficiency index PEI is 0.4 and the operation time OT is 10 minutes, the adjusted operation time OT_A may be 25 minutes.

According to the induction heating apparatus and the method for controlling the induction heating apparatus 100 of the present disclosure, at least one of the operation time or the target output power value may be adjusted based on the container efficiency index, so that the food can be completely cooked even with different properties of containers, thereby improving user satisfaction. In addition, the operation time may be adjusted only when the insufficient energy transmission due to the properties of the container is not compensated. Accordingly, the user's inconvenience as the operation is increased may be minimized.

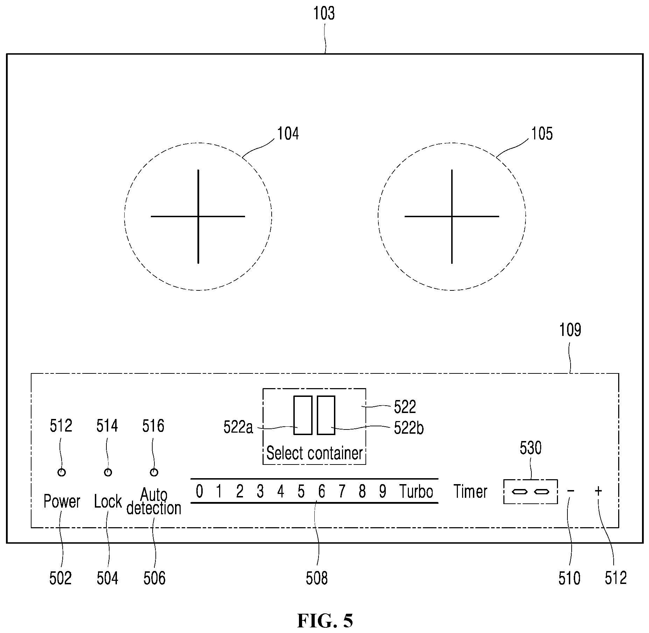

FIG. 5 shows an upper plate of the induction heating apparatus according to one embodiment.

Referring to FIG. 5, two heating regions 104 and 105 may be provided in the top plate 103 of the induction heating apparatus according to an embodiment of the present disclosure. A manipulation region 109 for controlling the heating of the container put on the heating regions 104 and 105 may be also provided in the top plate 103.

In the manipulation region 109, a button and a display area for controlling the heating of the container may be provided. The user can turn on or turn off the power of the induction heating apparatus by touching a power button 502. Whether power is applied may be indicated by where a power lamp 512 is lit.

The user may change the current state of the manipulation region 109 to a locked state or an unlocked state by touching a lock button 504 for a predetermined time period. When the manipulation region 109 is in the locked sate, input to all button provided in the manipulation region 109 may be blocked. The locked state of the induction heating apparatus 100 may be displayed by whether the lock lamp 514 is lit.

In addition, the user may touch an auto-detection button 506 to turn on or turn off the auto-detection function of the container. When a container is provided in the heating region 104 or 105 after the auto-container detection function is set, it may be displayed on a heating region selection window 522 whether the container is useable. Whether the auto-container detection function is set may be indicated by whether the auto-detection lamp 516 is lit.

The user may select the heating region to be heated by touching heating region selection buttons 522a and 522b respectively corresponding to the heating regions 104 and 105 in the heating region selection window 522. Also, the user may touch an output level setting button 508 to set an output level for the selected heating region.

In addition, the user may set a timer for the selected heating region by touching timer buttons 510 and 512. The time set by the user using the timer buttons 510 and 512 may be displayed on the timer window 530.

The user using the induction heating apparatus 100 having the configuration shown in FIG. 5 may check the container efficiency index of the containers provided on the heating regions 104 and 105 in real time by touching a specific button.

As one example, the user may touch the lock button 504 and the heating region selection button 522b at the same time to input a command for the container efficiency index of the container provided on the heating region 105, while the heating is performed based on the operation time and the target output power value received in a state where the user put the container on the heating region 105 selected by touching the heating region selection button 522b.

The controller 140 of the induction heating apparatus 100 may calculate the container efficiency index based on [Equation 1] according to the user's command, and display the calculated container efficiency index on the timer window 530 for a predetermined time period (e.g., 3 seconds). As one example, when the calculated container efficiency index is 0.4, the controller 140 may display the number '40' indicating that the current container efficiency index is 40% on the timer window 530.

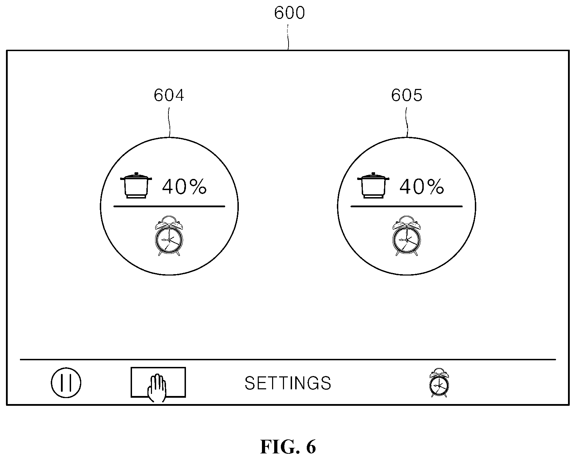

FIG. 6 shows a display provided in an induction heating apparatus according to another embodiment.

As shown in FIG. 6, the induction heating apparatus 100 according to another embodiment of the present disclosure may include a display 600 configured to display information related to the operation of the induction heating apparatus 100, separately from the manipulation region 109 shown in FIG. 5. The display 600 may be realized by a display device (i.e., LCD) and the present disclosure is not limited thereto.

On the display 600 may be displayed heating region icons 604 and 605 corresponding to the heating regions 104 and 105, respectively, as shown in FIG. 5. As mentioned above, when the user simultaneously touches the lock button 504 and the heating region selection button 522b or touches another button to command the output of the container efficiency index of the contained provided on the heating region 105, the controller 140 may display the container efficiency index (e.g., 40%) of the container provided on the heating region 105 may be displayed on the icon 605 corresponding to the heating region 105.

When the user commands to output the container efficiency index of the container provided on the heating region 104 and 105 using predetermined button combination or a separate button, the induction heating apparatus 100 may display the container efficiency index of the corresponding container on the manipulation region 109 or the display 600 in real time.

## Claims

1. A method for controlling an induction heating apparatus comprising steps of:

   receiving (S310) an operation time and a target output power value corresponding to product information of a product to be heated;
   driving (S320) a working coil (110) based on the operation time and the target output power value;
   measuring (S330) a resonance current value of the working coil (110);
   comparing (S340) the measured resonance current value with a preset reference current value;
   calculating (S350) a container efficiency index of a container provided on the working coil (110) based on an actual output power value of the working coil and the target output power value, when the resonance current value exceeds the reference current value; and
   adjusting (S360) at least one of the operation time and the target output power value based on the container efficiency index.

2. The method for controlling the induction heating apparatus of claim **1,** wherein the step of receiving (S310) the operation time and the target output power value includes:

inputting the product information to a user terminal and/or to the induction heating apparatus;
transmitting the product information to the managing server; and
receiving, by the induction heating apparatus, the operation time and the target output power value that correspond the product information from the managing server.

3. The method for controlling the induction heating apparatus of claim 1 or 2, wherein the container efficiency index is calculated by dividing the actual output power value by the target output power value.

4. The method for controlling the induction heating apparatus according to any one of the preceding claims, wherein the actual output power value is determined based on an actual input current sensed by an input current sensor and/or based on an actual input voltage sensed by an input voltage sensor.

5. The method for controlling the induction heating apparatus according to any one of the preceding claims, further comprising:

determining (S410) whether the target output power value is equal to a preset maximum output power value; and
adjusting (S420, S460) at least one of the operation time and the target output power value based on the result of the determination.

6. The method for controlling the induction heating apparatus according to any one of the preceding claims, further comprising:

adjusting (S460) the operation time based on the container efficiency index when the target output power value is equal to the maximum output power value (S410); and/or
adjusting (S420) the target output power value based on the container efficiency index if the target output power value is smaller than the maximum output power value (S410).

7. The method for controlling the induction heating apparatus of claim 6, further comprising:

re-adjusting (S440) the target output power value to be equal to the maximum output power value, when the adjusted target output power value exceeds the maximum output power value (S430); and
adjusting (S450) the operation time based on the received target output power value, the maximum output power value and the container efficiency index.

8. The method for controlling the induction heating apparatus according to any one of the preceding claims, further comprising:
driving the working coil (110) based on the adjusted target output power value and/or operation time.

9. An induction heating apparatus comprising:

a working coil (110) corresponding to a heating region (104, 105);
a communication unit (150) configured to transmit and/or receive information; and
a resonance current sensor (160) configured to measure a resonance current value of resonance current flowing through the working coil (110); and
a controller (140) configured to drive the working coil (110)
wherein the controller (140) is configured to perform a method according to any one of the preceding claims.

10. The induction heating apparatus of claim 9, further comprising:

an inverter circuit (120) comprising a plurality of switching elements (SW1, SW2) and being configured to supply a current to the working coil (110) for driving the same; and
a drive circuit (130) configured to supply a switching signal (S1, S2) to each of the switching elements (SW1, SW2);
wherein the controller (140) is configured to drive the working coil (110) by supplying a control signal for adjusting the switching signal (S1, S2) to the drive circuit (130).

11. The induction heating apparatus of claim 9 or 10, further comprising:

an input current sensor (170) configured to measure an input current value of current input to the induction heating apparatus; and/or
an input voltage sensor (180) configured to measure an input voltage value input to the induction heating apparatus.

12. The induction heating apparatus of claim 9, 10 or 11, further comprising:
a interface unit (108) for receiving a user input, in particular corresponding to the product information.

13. A system for controlling an induction heating apparatus, comprising:

an induction heating apparatus according to any one of claims 9 to 12; and
a managing server for determining at least one of the operation time and the target output power value and for transmitting the same to the induction heating apparatus.

14. The system according to claim 13, further comprising:
a user terminal for receiving a user input, in particular corresponding to the product information, and transmitting the same to the server.

**Patentansprüche**

1. Verfahren zum Steuern einer Induktionsheizvorrichtung, das die folgenden Schritte umfasst:

Empfangen (S310) einer Betriebszeit und eines Zielausgangsleistungswertes entsprechend den Produktinformationen eines zu erhitzenden Produkts;
Ansteuern (S320) einer Arbeitsspule (110) basierend auf der Betriebszeit und dem Zielausgangsleistungswert;
Messen (S330) eines Resonanzstromwertes der Arbeitsspule (110);
Vergleichen (S340) des gemessenen Resonanzstromwertes mit einem voreingestellten Referenzstromwert;
Berechnen (S350) eines Behälter-Effizienzindexes eines Behälters, der auf der Arbeitsspule (110) vorgesehen ist, basierend auf einem tatsächlichen Ausgangsleistungswert der Arbeitsspule und dem Zielausgangsleistungswert, wenn der Resonanzstromwert den Referenzstromwert übersteigt; und
Anpassen (S360) der Betriebszeit und/oder des Zielausgangsleistungswertes basierend auf dem Behälter-Effizienzindex.

2. Verfahren zum Steuern der Induktionsheizvorrichtung nach Anspruch 1, wobei der Schritt des Empfangens (S310) der Betriebszeit und des Zielausgangsleistungswertes Folgendes enthält:

Eingeben der Produktinformationen in ein Benutzerendgerät und/oder in die Induktionsheizvorrichtung;
Übertragen der Produktinformationen zu dem Verwaltungs-Server; und
Empfangen der Betriebszeit und des Zielausgangsleistungswertes, die den Produktinformationen entsprechen, durch die Induktionsheizvorrichtung, von dem Verwaltungs-Server.

3. Verfahren zum Steuern der Induktionsheizvorrichtung nach Anspruch 1 oder 2, wobei der Behälter-Effizienzindex durch Dividieren des tatsächlichen Ausgangsleistungswertes durch den Zielausgangsleistungswert berechnet wird.

4. Verfahren zum Steuern der Induktionsheizvorrichtung nach einem der vorhergehenden Ansprüche, wobei der tatsächliche Ausgangsleistungswert basierend auf einem tatsächlichen Eingangsstrom bestimmt wird, der durch einen Eingangsstromsensor erfasst wird, und/oder basierend auf einer tatsächlichen Eingangsspannung, die durch einen Eingangsspannungssensor erfasst wird.

5. Verfahren zum Steuern der Induktionsheizvorrichtung nach einem der vorhergehenden Ansprüche, das ferner Folgendes umfasst:

Bestimmen (S410), ob der Zielausgangsleistungswert gleich einem voreingestellten maximalen Ausgangsleistungswert ist; und
Anpassen (S420, S460) der Betriebszeit und/oder des Ausgangsleistungswertes basierend auf dem Ergebnis der Bestimmung.

6. Verfahren zum Steuern der Induktionsheizvorrichtung nach einem der vorhergehenden Ansprüche, das ferner Folgendes umfasst:

Anpassen (S460) der Betriebszeit basierend auf dem Behälter-Effizienzindex, wenn der Zielausgangsleistungswert gleich dem maximalen Ausgangsleistungswert (S410) ist: und/oder
Anpassen (S420) des Zielausgangsleistungswertes basierend auf dem Behälter-Effizienzindex, wenn der Zielausgangsleistungswert kleiner ist als der maximale Ausgangsleistungswert (S410).

7. Verfahren zum Steuern der Induktionsheizvorrichtung nach Anspruch 6, das ferner Folgendes umfasst:

erneutes Anpassen (S440) des Zielausgangsleistungswertes derart, dass er gleich dem maximalen Ausgangsleistungswert ist, wenn der angepasste Zielausgangsleistungswert den maximalen Ausgangsleistungswert (S430) überschreitet; und
Anpassen (S450) der Betriebszeit basierend auf dem empfangenen Zielausgangsleistungswert, dem maximalen Ausgangsleistungswert und dem Behälter-Effizienzindex.

8. Verfahren zum Steuern der Induktionsheizvorrichtung nach einem der vorhergehenden Ansprüche, das ferner Folgendes umfasst:
Ansteuern der Arbeitsspule (110) basierend auf dem angepassten Zielausgangsleistungswert und/oder der Betriebszeit.

9. Induktionsheizvorrichtung, die Folgendes umfasst:

eine Arbeitsspule (110), die einem Heizbereich (104, 105) entspricht;
eine Kommunikationseinheit (150), die konfiguriert ist, Informationen zu übertragen oder zu empfangen; und
einen Resonanzstromsensor (160), der konfiguriert ist, einen Resonanzstromwert des Resonanzstroms zu messen, der durch die Arbeitsspule (110) fließt; und
eine Steuereinrichtung (140), die konfiguriert ist, die Arbeitsspule (110) anzusteuern,
wobei die Steuereinrichtung (140) konfiguriert ist, ein Verfahren nach einem der vorhergehenden Ansprüche durchzuführen.

10. Induktionsheizvorrichtung nach Anspruch 9, die ferner Folgendes umfasst:

eine Wechselrichterschaltung (120), die mehrere Schaltelemente (SW1, SW2) umfasst und konfiguriert ist, der Arbeitsspule (110) einen Strom zuzuführen, um diese anzusteuern; und
eine Steuerschaltung (130), die konfiguriert ist, jedem der Schaltelemente (SW1, SW2) ein Schaltsignal (S1, S2) zuzuführen;
wobei die Steuereinrichtung (140) konfiguriert ist, die Arbeitsspule (110) anzusteuern, indem sie der Steuerschaltung (130) ein Steuersignal zum Anpassen des Schaltsignals (S1, S2) zuführt.

11. Induktionsheizvorrichtung nach Anspruch 9 oder 10, die ferner Folgendes umfasst:

einen Eingangsstromsensor (170), der konfiguriert ist, einen Eingangsstromwert des Stroms zu messen, der in die Induktionsheizvorrichtung eingegeben wird; und/oder
einen Eingangsspannungssensor (180), der konfiguriert ist, einen Eingangsspannungswert zu messen, der in die Induktionsheizvorrichtung eingegeben wird.

12. Induktionsheizvorrichtung nach Anspruch 9, 10 oder 11, die ferner Folgendes umfasst:
eine Schnittstelleneinheit (108) zum Empfangen einer Benutzereingabe, insbesondere entsprechend den Produktinformationen.

13. System zum Steuern einer Induktionsheizvorrichtung, das Folgendes umfasst:

eine Induktionsheizvorrichtung nach einem der Ansprüche 9 bis 12; und

einen Verwaltungs-Server zum Bestimmen der Betriebszeit und/oder des Zielausgangsleistungswertes und zum Übertragen dieser zu der Induktionsheizvorrichtung.

14. System nach Anspruch 13, das ferner Folgendes umfasst:
ein Benutzerendgerät zum Empfangen einer Benutzereingabe, insbesondere entsprechend den Produktinformationen, und zum Übertragen dieser zu dem Server.


**Revendications**

1. Procédé pour commander un appareil de chauffage par induction, comportant les étapes consistant à :

recevoir (S310) un temps de fonctionnement et une valeur de puissance de sortie cible correspondant à des informations de produit d'un produit à chauffer ;
exciter (S320) une bobine de travail (110) sur la base du temps de fonctionnement et de la valeur de puissance de sortie cible ;
mesurer (S330) une valeur de courant de résonance de la bobine de travail (110) ;
comparer (S340) la valeur de courant de résonance mesurée avec une valeur de courant de référence prédéfinie ;
calculer (S350) un indice d'efficacité de récipient d'un récipient disposé sur la bobine de travail (110) sur la base d'une valeur de puissance de sortie réelle de la bobine de travail et de la valeur de puissance de sortie cible, lorsque la valeur de courant de résonance dépasse la valeur de courant de référence ; et
régler (S360) au moins un élément parmi le temps de fonctionnement et la valeur de puissance de sortie cible sur la base de l'indice d'efficacité de récipient.

2. Procédé pour commander l'appareil de chauffage par induction selon la revendication 1, dans lequel l'étape de réception (S310) du temps de fonctionnement et de la valeur de puissance de sortie cible inclut de :

entrer des informations de produit dans un terminal d'utilisateur et/ou dans l'appareil de chauffage par induction ;
transmettre les informations de produit au serveur de gestion ; et
recevoir, par l'appareil de chauffage par induction, le temps de fonctionnement et la valeur de puissance de sortie cible correspondant aux informations de produit provenant du serveur de gestion.

**3.** Procédé pour commander l'appareil de chauffage par induction selon la revendication 1 ou 2, dans lequel l'indice d'efficacité de récipient est calculé en divisant la valeur de puissance de sortie réelle par la valeur de puissance de sortie cible.

**4.** Procédé pour commander l'appareil de chauffage par induction selon l'une quelconque des revendications précédentes, dans lequel la valeur de puissance de sortie réelle est déterminée sur la base d'un courant d'entrée réel détecté par un capteur de courant d'entrée et/ou sur la base d'une tension d'entrée réelle détectée par un capteur de tension d'entrée.

**5.** Procédé pour commander l'appareil de chauffage par induction selon l'une quelconque des revendications précédentes, comportant en outre de :

déterminer (S410) si la valeur de puissance de sortie cible est égale à une valeur de puissance de sortie maximale prédéfinie ; et régler (S420, S460) au moins un élément parmi le temps de fonctionnement et la valeur de puissance de sortie cible sur la base du résultat de la détermination.

**6.** Procédé pour commander l'appareil de chauffage par induction selon l'une quelconque des revendications précédentes, comportant en outre de :

régler (S460) le temps de fonctionnement sur la base de l'indice d'efficacité de récipient lorsque la valeur de puissance de sortie cible est égale à la valeur de puissance de sortie maximale (S410) ; et/ou régler (S420) la valeur de puissance de sortie cible sur la base de l'indice d'efficacité de récipient si la valeur de puissance de sortie cible est inférieure à la valeur de puissance de sortie maximale (S410).

**7.** Procédé pour commander l'appareil de chauffage par induction selon la revendication 6, comportant en outre de :

re-régler (S440) la valeur de puissance de sortie cible pour qu'elle soit égale à la valeur de puissance de sortie maximale, lorsque la valeur de puissance de sortie cible réglée dépasse la valeur de puissance de sortie maximale (S430) ; et régler (S450) le temps de fonctionnement sur la base de la valeur de puissance de sortie cible reçue, de la valeur de puissance de sortie maximale et de l'indice d'efficacité de récipient.

**8.** Procédé pour commander l'appareil de chauffage par induction selon l'une quelconque des revendications précédentes, comportant en outre de : exciter la bobine de travail (110) sur la base de la valeur de puissance de sortie cible réglée et/ou du temps de fonctionnement réglé.

**9.** Appareil de chauffage par induction comportant :

une bobine de travail (110) correspondant à une zone de chauffage (104, 105) ; une unité de communication (150) configurée pour transmettre et/ou recevoir des informations ; et un capteur de courant de résonance (160) configuré pour mesurer une valeur de courant de résonance d'un courant de résonance circulant à travers la bobine de travail (110) ; et une commande (140) configurée pour exciter la bobine de travail (110) dans lequel la commande (140) est configurée pour mettre en œuvre un procédé selon l'une quelconque des revendications précédentes.

**10.** Appareil de chauffage par induction selon la revendication 9, comportant en outre :

un circuit inverseur (120) comportant une pluralité d'éléments de commutation (SW1, SW2) et étant configuré pour fournir un courant à la bobine de travail (110) afin d'exciter celle-ci ; et un circuit d'excitation (130) configuré pour fournir un signal de commutation (S1, S2) à chacun des éléments de commutation (SW1, SW2) ; dans lequel la commande (140) est configurée pour exciter la bobine de travail (110) en fournissant au circuit d'excitation (130) un signal de commande pour régler le signal de commutation (S1, S2).

**11.** Appareil de chauffage par induction selon la revendication 9 ou 10, comportant en outre :

un capteur de courant d'entrée (170) configuré pour mesurer une valeur de courant d'entrée d'un courant appliqué à l'entrée de l'appareil de chauffage par induction ; et/ou un capteur de tension d'entrée (180) configuré pour mesurer une valeur de tension d'entrée appliquée à l'entrée de l'appareil de chauffage par induction.

**12.** Appareil de chauffage par induction selon la revendication 9, 10 ou 11, comportant en outre : une unité d'interface (108) pour recevoir une entrée d'utilisateur, correspondant en particulier aux informations de produit.

**13.** Système pour commander un appareil de chauffage par induction, comportant :

un appareil de chauffage par induction selon l'une quelconque des revendications 9 à 12 ; et un serveur de gestion pour déterminer au moins un élément parmi le temps de fonctionnement et la valeur de puissance de sortie cible et pour transmettre celui-ci à l'appareil de chauffage par induction.

14. Système selon la revendication 13, comportant en outre :
un terminal d'utilisateur destiné à recevoir une entrée d'utilisateur, correspondant en particulier aux informations de produit, et transmettre celle-ci au serveur.

**FIG. 1**

**FIG. 2**

```
              ┌─────────┐
              │  Start  │
              └────┬────┘
                   │           ╱ S310
         ┌─────────▼──────────────────────┐
         │ Receiving an operation time and a target output │
         │ power value corresponding to product information │
         └─────────┬──────────────────────┘
                   │           ╱ S320
         ┌─────────▼──────────────────────┐
         │ Driving a working coil based on the operation time │
         │ and the target output power value │
         └─────────┬──────────────────────┘
                   │           ╱ S330
         ┌─────────▼──────────────────────┐
         │ Measuring a resonance current value of the working coil │
         └─────────┬──────────────────────┘
                   │           ╱ S340
                  ╱ ╲
                 ╱   ╲     Resonance
                ╱ current value exceeds Preset reference ╲ ──── No
                ╲     current value?     ╱
                 ╲   ╱
                  ╲ ╱
                   │ Yes        ╱ S350
         ┌─────────▼──────────────────────┐
         │ Calculating a container efficiency index of a container │
         │ provided on the working coil based on an actual output │
         │ power value of the working coil and the target output │
         │ power value, when the resonance current value │
         │ exceeds the reference current value │
         └─────────┬──────────────────────┘
                   │           ╱ S360
         ┌─────────▼──────────────────────┐
         │ Adjusting at least one of the operation time or the target │
         │ output power value based on the container efficiency index │
         └─────────┬──────────────────────┘
                   │
              ┌────▼────┐
              │   End   │
              └─────────┘
```

**FIG. 3**

Start

Is target output
power value equal to maximum output
power value?  — S410

Yes → Adjusting the operation time based on the container efficiency index  — S460

No  — S420

Adjusting the target output power value based on the container efficiency index

Adjusted target
output power value > Maximum output
power value?  — S430

No →

Yes  — S440

Re-adjusting the maximum output power value to be the target output power value

Adjusting the operation time based on the initial target output power value, the maximum output power value and the container efficiency index  — S450

End

**FIG. 4**

103

104                                    105

109

512   514   516          522
                522a ─┤  ├─ 522b
                  Select container           530

Power  Lock  Auto      0 1 2 3 4 5 6 7 8 9 Turbo   Timer   ⊖ ⊖   −   +
             detection

502   504   506                  508                        510  512

**FIG. 5**

20

600

604                                   605

🍲 40%                          🍲 40%

⏰                                ⏰

(II)   [🖐]        SETTINGS              ⏰

**FIG. 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3481147 A1
- JP 2009295330 A
- EP 3764740 A1
- EP 2642820 A1
- KR 1020120117463